# EUROPEAN PATENT SPECIFICATION

(11) **EP 1 703 780 B1**
(45) Date of publication and mention of the grant of the patent: **06.05.2015**
(21) Application number: 06251457.5
(22) Date of filing: 17.03.2006
(51) Int. Cl.: H05K 1/14

(54) **Printed wiring board with an FPC connector**
Leiterplatte mit einem Steckverbinder für eine flexible Leiterplatte
Plaque de circuit imprimé avec un connecteur pour un circuit imprimé flexible

(30) Priority: 17.03.2005 JP 2005078244; 13.10.2005 JP 2005299000
(43) Date of publication of application: 20.09.2006
(73) Proprietor: Ricoh Company, Ltd., Tokyo 143-8555 (JP)
(72) Inventor: Nakahira, Toshiaki, Tokyo 143-8555 (JP)
(74) Representative: Leeming, John Gerard

(56) References cited:
- JP-A- 8 006 726
- US-A- 5 598 627
- PATENT ABSTRACTS OF JAPAN vol. 2002, no. 03, 3 April 2002 (2002-04-03) -& JP 2001 332829 A (OLYMPUS OPTICAL CO LTD), 30 November 2001 (2001-11-30)
- PATENT ABSTRACTS OF JAPAN vol. 2003, no. 07, 3 July 2003 (2003-07-03) -& JP 2003 069180 A (CANON INC), 7 March 2003 (2003-03-07)
- PATENT ABSTRACTS OF JAPAN vol. 018, no. 570 (E-1623), 31 October 1994 (1994-10-31) -& JP 06 209066 A (NEC NIIGATA LTD), 26 July 1994 (1994-07-26)

## Description

The present invention relates to a print wired board and an imaging apparatus using the print wired board.

Recently, various models of a digital still camera increasingly go on a market at once. A new model sometimes changes a specification of an imaging lens, such as a focal point, a zoom magnification, a F-number, a number of steps of a diaphragm, etc., a number of pixels of imaging elements, a size of a LCD, and a type of a recordation media for recording an image or the like, while maintaining a fundamental architecture, such as an electric circuit, etc., as far as possible. In such a situation, a baseboard conventionally needs to be manufactured every time when a new model is developed. Thus, substantially the same labor is repeated when a model having completely different design is developed. A prescribed baseboard can resolve such a problem if it is enabled to accommodate a plurality of imaging elements, recordation mediums, and lens units to serve any one of a plurality of print circuit boards (PCB) in accordance with a manner of mounting an electronic part or a module and the like.

However, when a high versatility baseboard is produced without careful consideration, the baseboard unavoidably becomes large. As a result, it goes against a recent large demand of a downsized imaging apparatus.

Then, there are various ideas and practical uses of a driver IC capable of accommodating a plurality of imaging elements and a LCD, as well as a baseboard capable of accommodating a plurality of recordation mediums as discussed in Japanese Patent Application Laid Open No. 2001-313858. Specifically, it proposes an electronic camera apparatus capable of selectively adding a miscellaneous function or an expansion function without spoiling portability. That is, the electronic camera apparatus includes interior layout in which a first card slot for main memory card use and a second card slot for accessory use are mounted on front and rear sides of a main baseboard, respectively, with their card slots being in parallel to a front side surface of the camera body.

However, there are no ideas which provide a baseboard capable of accommodating a plurality of lens units. Generally, signal lines are wired on the rear and side surfaces as well as an interior using a flexible printed circuit baseboard (FPC) in the lens unit so as to reach an actuator that drives a lens group, a shutter, and a diaphragm or the like in order to detect a position of the lens group. These signal lines, on the other hand, are connected to a baseboard on which a driver or a CPU and the like is mounted to input and output signals via a FPC use connector. However, the below described problems are raised when a single baseboard accommodates a plurality of lens units.

Since a layout of an actuator and a position detection element vary depend on a lens unit, and an order of signal lines drawn from the lens unit is not the same. The order of signals can be replaced if a multiple layer type FPC is utilized. However, the FPC becomes costly and loses flexibility due to increase in thickness. In addition, the signal lines can't be wired around the lens unit as intended.

Further, it is possible to arrange only a connector on a baseboard and employ lands twice a number of signal lines for jumper chip use so as to replace signal lines connected to the connector, and change a jumper chip in accordance with a lens unit.

However, the above-mentioned connector needs at least ten signal lines, and accordingly about 100mA flows through output lines for actuator use if a lens unit includes a zoom function, a diaphragm, and a shutter function. As a result, relatively fatter signal lines, and accordingly, a significantly large space are needed to secure a prescribed voltage to be applied to the motor while suppressing drop of the least operable voltage in the lens unit.

Further, a function test (FT) is sometimes executed per baseboard before building the baseboard into a product. The test is executed supposing that a baseboard mounting parts is built-in a camera. However, it is inefficient if the test is executed while a FPC or the like is practically inserted into the above-mentioned connector or the like. Then, a FT private use land called FT pad is generally arranged on the baseboard so as to obtain a necessary signal by contacting a probe pin thereto to test. Further, when a connector for plural lens unit use can be mounted, while a FT pad is additionally employed, a significantly large space is needed.

JP 8 006726 A discloses a printed circuit board and magnetic disk device in which a manufacturing cost is lowered by enabling two kinds of connector interface of different shapes to be connected to one kind of printed circuit board. In a disclosed printed circuit board, a first connection pad part for mounting the first connector is formed in its surface, and a second connection pad for mounting a second connector is formed on a rear surface. The lower projection part of the contactors of the first connector are bent at right angles and the contactors of the second connector are all bent upward to enable surface mounting on the printed circuit board. A decision part is enabled to decide which interface connector is connected.

It is an object of the present invention to provide a downsized and low cost print wired board and an imaging apparatus using the print wired board defined in the appended claim 1. Further embodiments are defined in the dependent claims.
FIG. 1 illustrates an exemplary print wired board commonly used by a plurality of electronic parts driven by the same driver;
FIG. 2 illustrates an exemplary print wired board commonly used by a plurality of electronic parts driven by two drivers, respectively;
FIG. 3 illustrates an exemplary print circuit board commonly used by a plurality of lens units driven by a commonly used driver;
FIG. 4 illustrates an exemplary print circuit board commonly used by a plurality of lens units and CCD units driven by a commonly used driver;
FIG. 5 illustrates an exemplary vicinity of a FPC connector of a print wired board according to a first arrangement;
FIG. 6 illustrates an exemplary vicinity of a FPC connector of a print wired board according to a second arrangement;
FIG. 7 illustrates an exemplary vicinity of a FPC connector of a print wired board according to a third arrangement; and
FIG. 8 illustrates an exemplary vicinity of a FPC connector of a print wired board according to a fourth arrangement.

If an arrangement order of signal lines (i.e., wiring) of an electronic part is different and the electronic part is driven by a common circuit and a driver, a FPC connector used to connect an electronic part, a module, and the like onto a print wired board can't be commonly used. Then, according to the present invention, in order to allow all of a plurality of electronic parts having similar functions and thus driven by a common driver mounted on a print wired board having the same wiring patterns, a prescribed number of different FPC connectors are mounted on the print wired board corresponding to an number of different arrangements of signal lines of the FPC. Thus, the print wired board of the present invention includes a prescribed number of connector lands corresponding to the different arrangements.

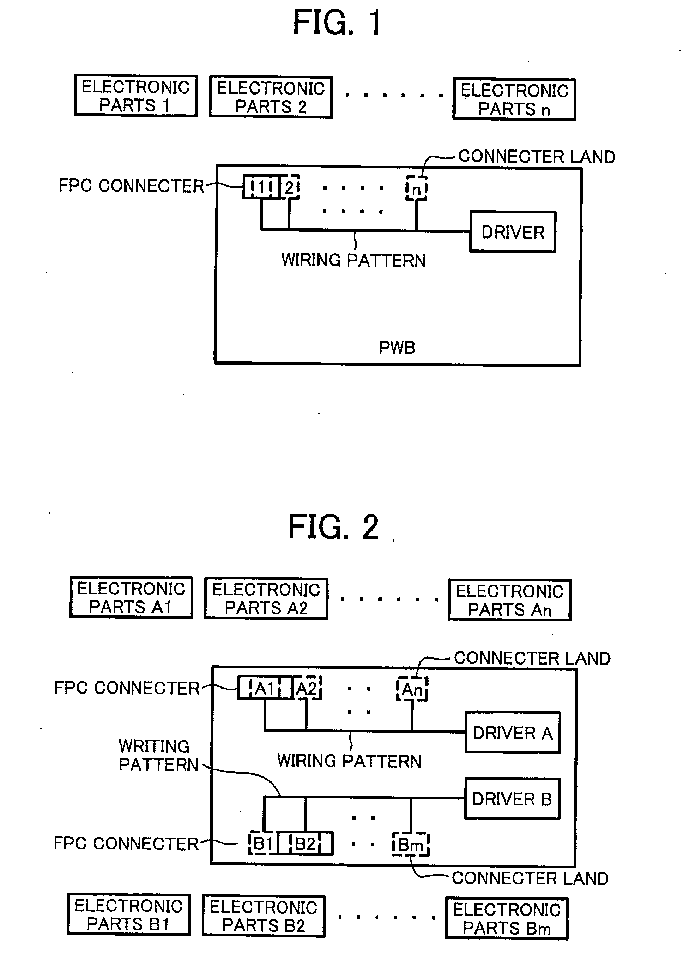

For example, as shown in FIG. 1, when n number of different types of electronic parts are driven by a common driver while an order of arrangement of FPC signal lines are different from each other, a print wired board provides n types of different connector lands. Specifically, the print wired board includes n items of the connector lands.

Further, the wiring pattern of the print wired board substantially branches off into n-items, including when a connector land is provided at a middle point of the wiring pattern and a wiring length of a branching destination is zero.

Then, a FPC connector is mounted to one of n-items of the connector lands corresponding to the arrangement order of the wiring of the FPC.

When a print wired board mounts two or more drivers, each of the drivers is assigned with the above-mentioned number of FPC connectors and connector lands. For example, as shown in FIG. 2, when n types of electronic parts A are driven by a driver A and m types of electronic parts B are driven by a driver B, and an order of arrangement of FPC signal lines of each of the electronic parts A and B is different from the other, a print wired board mounts n types of FPC connectors for the electronic part A use, and m types of FPC connectors for the electronic part B use. Specifically, the print wired board includes n items of connector lands for the electronic part A use, and m items of connector lands for the electronic part B use.

Now, one example when an electronic part is a lens unit driven by a common driver is described.

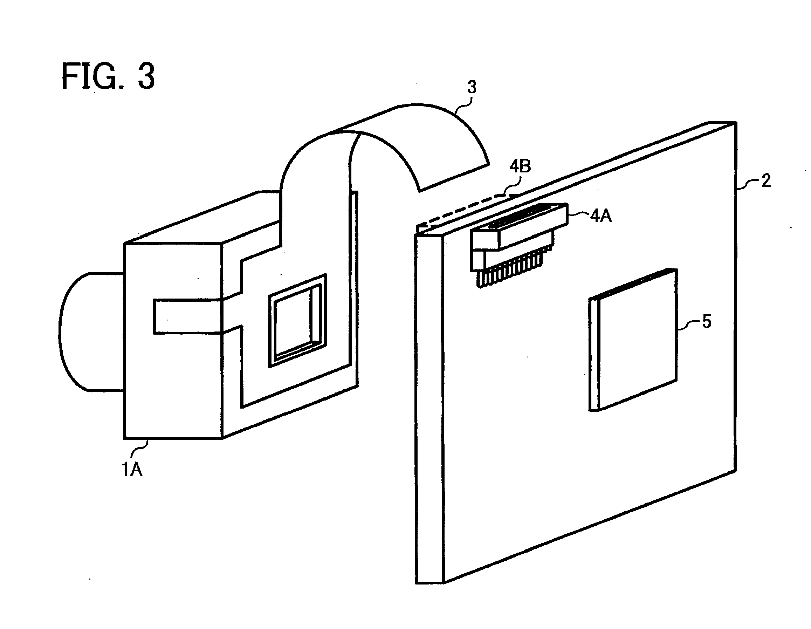

FIG. 3 illustrates a condition in which an imaging apparatus is divided into some units, and a lens unit thereof is connected to a print wired board. As shown, one of two types of lens units 1A and 1B (1A, in the drawing) is just connected to a print wired board 2 for common imaging apparatus use. A FPC 3 is connected to the lens unit 1A (or 1B). A plurality of FPC connectors 4A and 4B (4A, in FIG. 3) is arranged on the print wired board 2 so as to connect the FPC 3. Numeral 5 denotes an image formation use LSI mounted on the print wired board 2.

Thus, the print wired board 2 can accept usage of all of the lens units 1A and 1B when one of two types of FPC connectors 4A and 4B can be mounted and a wiring pattern of a print wired board 2 is formed to be commonly used by lens units 1A and 1B.

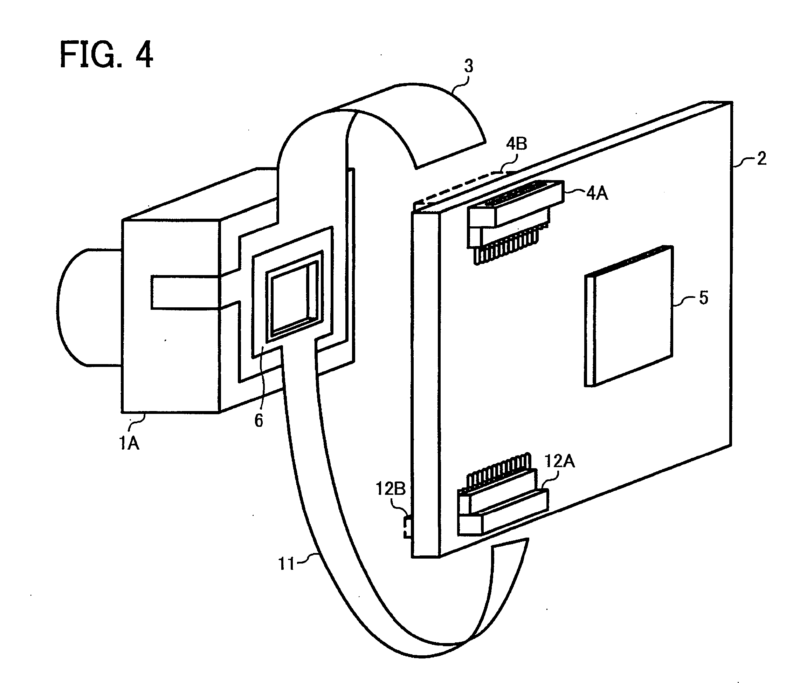

Further, when two types of CCD unit 6A and 6B, are handled, it is preferable that two types of FPC connectors 12A and 12B are mountable so as to connect a FPC 11 of the CCD unit 6 as shown in FIG. 4.

Herein after, a configuration of a print wired board capable of mounting any one of a plurality of FPC connectors is described supposing that an electronic part driven by a common driver is a lens unit.

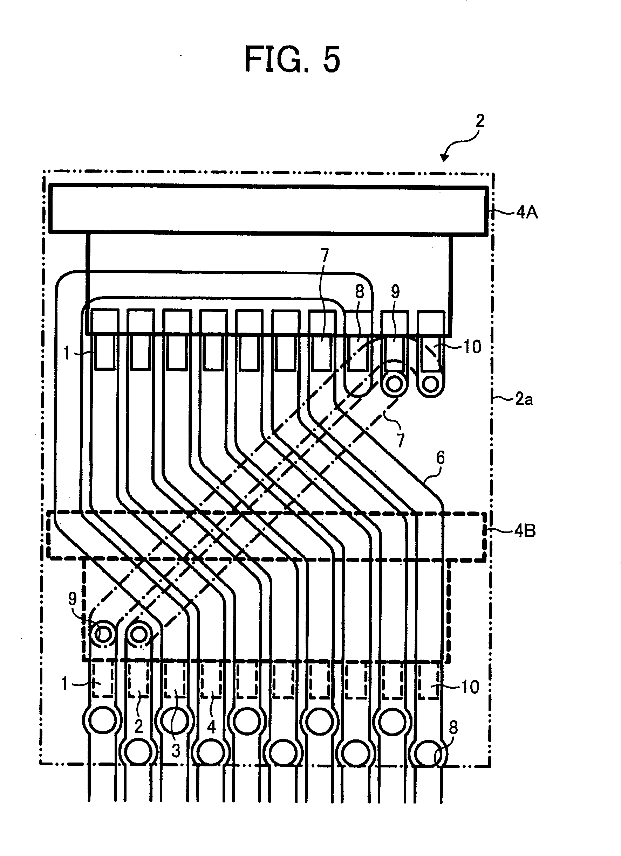

A first arrangement, which is not an embodiment of the invention but represents background art useful for understanding the invention, is now described. FIG. 5 illustrates an exemplary connector 4 and its vicinity of a print wired board 2, wherein the same reference numbers are assigned to corresponding parts to omit repetitious explanation. In this example, only a connector 4A is provided to handle a pair of lens units 1A and 1B. In the drawing, when the below mentioned wiring pattern is connected, first to seventh pins of the FPC connector 4A correspond to fourth to tenth pins of the FPC connectors 4B, and seventh to ninth pins of the FPC connector 4A correspond to third to first pins of the FPC connectors 4B.

A thick solid line represents a contour of the FPC connecter 4A, and a thick dotted line represents a contour of the FPC connecter 4B exclusively mounted. A thin solid line 6 represents a top layer pattern of the print wired board 2, and a dotted line 7 represents an inner layer pattern of the print wired board 2. A large circle 8 represents a common use FT pad for FT use, and a small circle 9 represents a through hole. A region 2a surrounded by a two dotted line has the smallest rectangular shape that includes the contours of the FPC connectors 4A and 4B, wiring of respective patterns, and the common use FT pad 8. The region 2a is necessary on the print wired board 2 especially to mount one of the FPC connectors 4A and 4B and arrange the FT pad. The top layer pattern 6 connects the eighth pin of the FPC connector 4A to third pin of the FPC connector 4B, while connecting the first to seventh pins of the FPC connector 4A to fourth to tenth pins of the of the FPC connector 4B, respectively. The inner layer 7 connects the ninth and tenth pins of the FPC connector 4A to the second and first pins of the FPC connector 4B, respectively.

According to this arrangement, since a plurality of connector lands are arranged on the PWB 2 so as to enable to mount any one of the FPC connecters 4A and 4B in accordance with the FPCs 3 and 4 of the lens units 1A and 1B, only one PWB 2 can handle the plurality of lens units 1A and 1B.

A second arrangement is now described, which is an embodiment of the invention. Since electronic parts driven by the common driver are exclusively mounted on a print wired board, none of devices is mounted on one of a plurality of connector lands and thus is spaced when a FPC connector is mounted on the other one of a plurality of connector lands. Thus, a PWB is formed such that a space for mounting an optional FPC connector partially overlaps with that for practically mounting another FPC connector. Thus, a total area (i.e., a necessary area) for mounting the FPC connector can be reduced.

Further, when a flexible baseboard is connected to a FPC connector, a print circuit board is partially covered by the FPC, and can't mount the other electronic parts at the portion. However, since a FT is used before the flexible baseboard is connected, a FT use land can be formed on the portion covered by the flexible baseboard without a problem. Thus, it can be overlapped with a space not mounting the connector.

According to the PWB of this embodiment, a space for mounting a connector is reduced.

A vicinity of a FPC connector of an imaging apparatus according to this embodiment is described in detail. The same reference numbers are assigned as those in FIG. 5 to omit repetitious explanation. Specifically, FIG.S 6A and 6B are front and side views of a PWB. An area of a contour of a FPC connector 4A represented by a thick solid line overlaps with that of a FPC connector 4B represented by a thick dotted line, when exclusively mounted, on the same plane of the PWB 2 so that respective connector connecting directions are the same. Because, when an imaging apparatus is practically made into a product, only one lens unit is used per product. Since these FPC connectors 4A and 4B are exclusively used, patterns can be laid out so that respective connectors overlap with each other without a problem.

Since a bottom surface of the FPC connector is generally covered by insulation material, a FT pad 8B is generally arranged on the bottom surface of the FPC connector 4A of the baseboard for inspection use when a FPC connector 4Bis mounted. A FT pad 8A is also arranged on the bottom surface of the FPC connector 4B for inspection use when a FPC connector 4A is mounted. These FT pads 8A and 8B are arranged almost inside the contours of respective connectors. A type of lines of a wiring pattern is almost the same as in FIG. 5.

When the FPC connector 4A is mounted on the PWB 2, the FT pad 8B disappears under the FPC connector 4A. However, since the FPC connector 4B is not mounted when the FPC connector 4A is mounted, the FT pad 8B is not used. Thus, it does not cause problems even if the FT pad 8B disappears under the FPC connector 4A. When the FPC connector 4B is mounted on the PWB 2, the FT pad 8A disappears under the FPC connector 4B. However, since the FPC connector 4A is not mounted when the FPC connector 4B is mounted, the FT pad 8Ais not used. Thus, it does not cause problems even if the FT pad 8A disappears under the FPC connector 4B.

Since the FPC 3 covers the surface of the FPC connector 4B when the FPC3 is connected to the FPC connector 4B, the region can't mount the other electronic parts. However, the FT pad 8B is used for inspection before the FPC is connected to the FPC connector 4B, and has no height (i.e., does not protrude from the PWB 2), it does not cause problems even if the FT pad 8B is arranged on the surface of the other connector.

Thus, a necessary region 2a of this embodiment shown by the two dotted line is smaller than that described with reference to FIG. 5. In other words, since regions inside the contour of the other FPC connector and the surface of the FPC connector are dead space unavailable for the other electronic parts, a space for mounting the other electronic parts can be saved if a FT is arranged therein.

Although the connector land is formed such that the regions inside the contours of the two FPC connectors partially overlap with the other in this example, the connector land is formed such that the regions inside the contours of the FPC connectors corresponding to electronic parts can partially overlap with the other when more than three electronic parts are exclusively mounted.

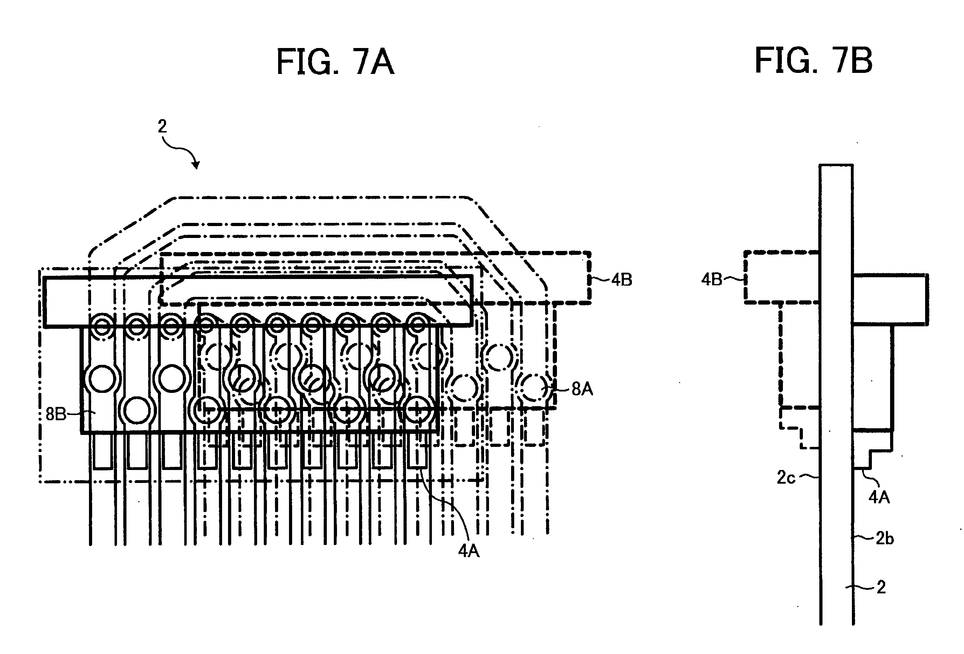

A third arrangement, which is not an embodiment of the invention but represents background art useful for understanding the invention, is now described. Even if one of the FPC connectors 4A and 4B is mounted on the same plane of the PWB 2 in the first and second embodiments, these can be mounted on different planes on the PWB 2 as shown in FIG. 7 in which front and side views of the PCB are illustrated.

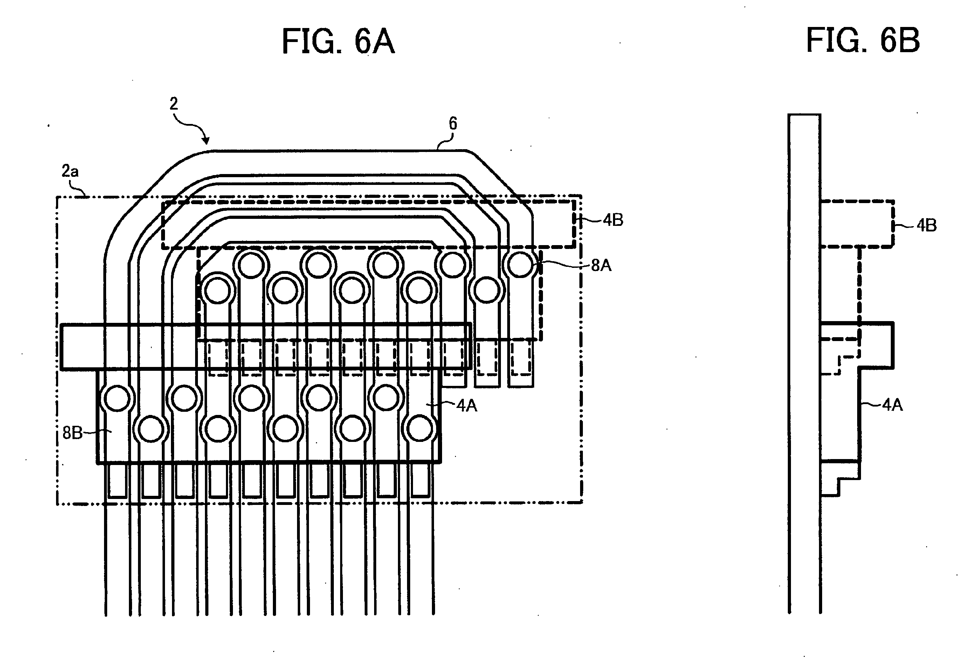

As shown, FIG. 7 illustrates an exemplary portion in the vicinity of a FPC connector of an imaging apparatus according to the third arrangment. The same reference numbers to those in FIG. 5 are assigned to corresponding sections in FIG. 7. Specifically, the plane 2b mounts the FPC connector 4A having a contour drawn by a thick solid line. The plane 2c is oppositely arranged and mounts the FPC connector 4B having a contour drawn by a thick dotted line. In addition, these planes are arranged in substantially the same positional relations on the two dimension defined by X and Y-axis on the surface of the PCB. Specifically, the mounting spaces for the FPC connectors 4A and 4B uses are substantially symmetrically arranged regarding the PWB 2 serving as a symmetry plane. Similar to the embodiment of FIG. 6, since two connectors are exclusively used, and a bottom surface of the FPC connector is covered by insulation material when an imaging apparatus is practically made into a product, a FT pad 8B for FPC connector 4B mounting use is arranged on the bottom surface of the FPC connector 4A, while a FT pad 8A for FPC connector 4A mounting use is arranged on the bottom surface of the FPC connector 4B. A type of lines of a wiring pattern is substantially the same to that in FIG. 5.

In this arrangement, even if the total front and rear side necessary region 2a shown by the two dotted line is the same as that in FIG. 6, the necessary area per plane can be almost half. Further, a necessary area of a conventional PWB impossible to handle a plurality of lens units can even be reduced by an amount of the FT pad per plane.

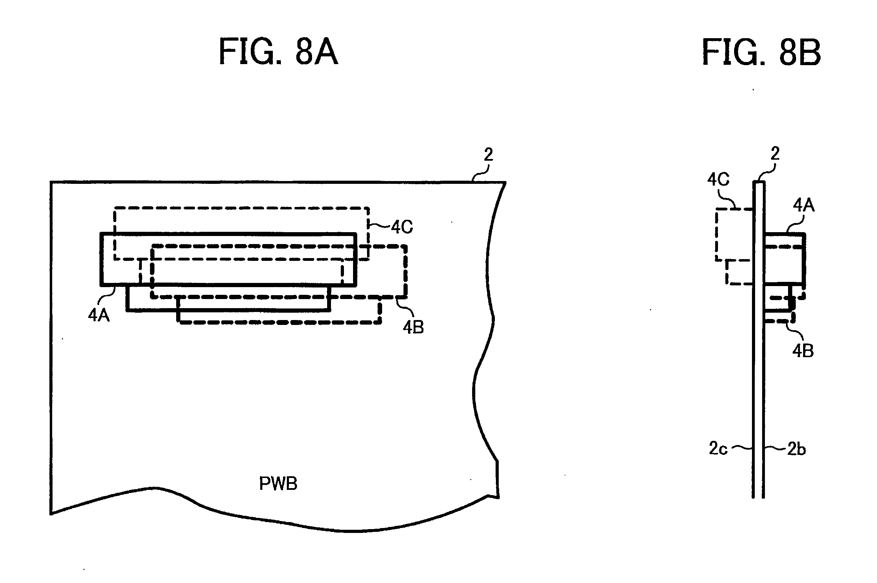

A fourth arrangement, which is an embodiment of the invention, is now described with reference to FIG. 8. As shown, a portion in the vicinity of an exemplary FPC connector of an imaging apparatus is described. One of FPCs 4A to 4C is mounted on a PWB 2. A plurality of spaces for mounting FPC connectors 4A and 4B are located on the same plane, and a space for mounting a FPC connector 4C is located on a plane opposite to the other FPC connectors 4A and 4B. For the easy comprehension of a configuration, only a region inside a contour of a connector is illustrated in the drawing while omitting a connector land, a FT pad, and a wiring pattern or the like.

A region inside a contour of a FPC connector 4A shown by a thick solid line overlaps with that of a FPC connector 4B represented by a thick dotted line, when exclusively mounted, on the same plane of the PWB 2 while respective connector surfaces are arranged in the same direction. Further, the plane 2b mounts the FPC connector 4A having a contour drawn by a thick solid line. The plane 2c is arranged opposite thereto and mounts the FPC connector 4C having a contour drawn by a thick dotted line.

Further, these planes are arranged in substantially the same positional relations on the two dimension defined by X and Y-axis of the surface of the baseboard.

Specifically, the mounting spaces for the FPC connectors 4A and 4C are substantially symmetrically arranged regarding the PWB 2 serving as a symmetry plane.

Specifically, this embodiment can be combination of the first and second arrangements. Thus, similar to these embodiments, an area (necessary area) to be secured in the PWB 2 so as to selectively mount one of the plurality of FPC connectors can be reduced.

Accordingly, the present invention can be applied to a digital video camera, a personal computer, and a mobile phone or the like including an imaging apparatus at least having a PWB with a lens unit and various ICs for driving the lens unit.

## Claims

1. A print wired board comprising:
at least one common driver (A) configured to commonly drive at least two electronic parts;
a wired pattern connected to the common driver (A) at one end, said wired pattern being separated into at least two sections at the other end;
at least two connector lands connected to the at least two sections; and a
first FPC connector (4A) including at least two pins (1-10) and connected to a first one of said at least two connector lands, wherein:
said common driver (A) is configured to drive a first one of said at least two electronic parts via a prescribed flexible board (3) connected to the first FPC connector (4A);
said common driver (A) is configured to drive a second one of said at least two electronic parts via a prescribed flexible board connected to a second FPC connector (4B) including at least two pins (1-10) and connectable to a second one of said at least two connector lands when the first FPC connector (4A) is disconnected from the first one of said at least two connector lands; and **characterised in that** the first and second ones of said at least two connector lands are arranged on the same side of the print wired board and in such a way that the space for mounting the first FPC connector (4A) to the first one of said at least two connector lands partially overlaps with the space for mounting the second FPC connector (4B) to the second one of said at least two connector lands.

2. The print wired board as claimed in claim 1 further comprising at least two inspection lands (8, 8A, 8B) mounted on the prescribed patterns and configured to allow a cable check for the at least two electronic parts, wherein a first one of the at least two inspection lands is configured to allow a cable check for the first one of the electronic parts and is arranged either on a region on which the second FPC connector (4B) is configured to be mounted or is covered by the flexible board (3) connected to the second FPC connector (4B) when the second FPC connector (4B) is mounted.

3. The print wired board as claimed in claim 2, wherein the connecting direction of the first and second FPC connectors (4A, 4B) is the same, and the print wired board is configured such that the second one of said connector lands is partially covered by the flexible board (3) connected to the first FPC connector (4A).

4. An imaging apparatus comprising a print wired board (2) according to one of claims 1 to 3, wherein said electronic parts include a lens unit having a camera cone, an optical element (6), and a motor configured to move the optical element (6) in the camera cone.

## Patentansprüche

1. Druck-verdrahtete Leiterplatte, die aufweist:
zumindest ein gemeinsamer Treiber (A) der konfiguriert ist, um gemeinsam zumindest zwei elektronische Teile zu treiben;
ein verdrahtetes Muster, das an dem gemeinsamen Treiber (A) an einem Ende angeschlossen ist, wobei das verdrahtete Muster in zumindest zwei Abschnitte an dem anderen Ende separiert bzw. getrennt ist;
zumindest zwei Verbinder-Kontaktflecke bzw. Verbinder-Anschlüsse, die an die zumindest zwei Abschnitte angeschlossen sind bzw. mit diesen verbunden sind; und
einen ersten FPC-Verbinder (4A), der zumindest zwei Stifte bzw. Pins (1-10) einschließt bzw. beinhaltet und an einem Ersten von den zumindest zwei Verbinder-Kontaktflecken bzw. Verbinder-Anschlüssen angeschlossen ist, wobei:
der gemeinsame Treiber (A) konfiguriert ist, um einen Ersten von den zumindest zwei elektronischen Teilen zu treiben, und zwar über eine vorbestimmte bzw. vorgeschriebene flexible Leiterplatte (3), die an den ersten FPC-Verbinder (4A) angeschlossen ist;
der gemeinsame Treiber (A) konfiguriert ist, um einen Zweiten von den zumindest zwei elektronischen Teilen zu treiben, und zwar über eine vorbestimmte bzw. vorgeschriebene flexible Leiterplatte, die an den zweiten FPC-Verbinder (4B) angeschlossen ist, der zumindest zwei Stifte bzw. Pins (1-10) einschließt bzw. beinhaltet und an einen Zweiten von den zumindest zwei Verbinder-Kontaktflecken bzw. Verbinder-Anschlüssen anschließbar ist, wenn der erste FPC-Verbinder (4A) von dem Ersten der zumindest zwei Verbinder-Kontaktflecken bzw. Verbinder-Anschlüssen getrennt ist bzw. nicht mit diesem verbunden ist; und
**dadurch gekennzeichnet, dass**
der Erste und Zweite der zumindest zwei Verbinder-Kontaktflecken bzw. Verbinder-Anschlüssen auf derselben Seite von der Druck-verdrahteten Leiterplatte angeordnet sind, und zwar der Art, dass der Raum bzw. Platz zum Befestigen des ersten FPC-Verbinders (4A) an den Ersten der zumindest zwei Verbinder-Kontaktflecken bzw. Verbinder-Anschlüssen teilweise mit dem Raum bzw. Platz zum Befestigen des zweiten FPC-Verbinders (4B) an den Zweiten der zumindest zwei Verbinder-Kontaktflecken bzw. Verbinder-Anschlüssen überlappt.

2. Druck-verdrahtete Leiterplatte nach Anspruch 1, weiter aufweisend zumindest zwei Inspektionskontaktflecken bzw. Inspektionsanschlüsse (8, 8A, 8B), die auf den vorbestimmten bzw. vorgeschriebenen Mustern befestigt bzw. angeordnet sind, und konfiguriert sind, um eine Kabelprüfung bzw. einen Kabelcheck für die zumindest zwei elektronischen Teile zu ermöglichen bzw. zu erlauben, wobei ein Erster der zumindest zwei Inspektionskontaktflecken bzw. Inspektionsanschlüssen konfiguriert ist, um eine Kabelprüfung bzw. einen Kabelcheck für das Erste der elektronischen Teile zu ermöglichen bzw. zu erlauben und entweder auf einem Bereich angeordnet ist, auf welchem der zweite FPC-Verbinder (4B) konfiguriert ist, angeordnet zu sein, oder durch die flexible Leiterplatte (3) abgedeckt ist, die an den zweiten FPC-Verbinder (4B) angeschlossen ist, wenn der zweite FPC-Verbinder (4B) befestigt ist.

3. Druck-verdrahtete Leiterplatte nach Anspruch 2, wobei die Verbindungsrichtung der ersten und zweiten FPC-Verbinder (4A, 4B) dieselbe ist, und die Druck-verdrahtete Leiterplatte konfiguriert ist, sodass der Zweite von den Verbinder-Kontaktflecken bzw. Verbinder-Anschlüssen teilweise durch die flexible Leiterplatte (3) abgedeckt ist, die an den ersten FPC-Verbinder (4A) angeschlossen ist.

4. Abbildungsvorrichtung, die eine Druck-verdrahtete Leiterplatte (2) nach irgendeinem der Ansprüche 1 bis 3 aufweist, wobei die elektronischen Teile eine Linseneinheit mit einem Kamerakegel bzw. einem Kamerakonus oder einer Kameraverjüngung, einem optischen Element (6) und einem Motor einschließen, der konfiguriert ist, um das optische Element (6) in den Kamerakegel bzw. Kamerakonus oder die Kameraverjüngung zu bewegen.

## Revendications

1. Carte de circuit imprimé comprenant :
au moins un pilote commun (A) configuré pour piloter communément au moins deux parties électroniques ;
une forme câblée raccordée au pilote commun (A) au niveau d'une extrémité, ladite forme câblée étant séparée en au moins deux sections au niveau de l'autre extrémité ;
au moins deux plages d'accueil de connecteur raccordées aux au moins deux sections ; et
un premier connecteur de FPC (circuit imprimé flexible) (4A) comprenant au moins deux broches (1-10) et raccordé à une première desdites au moins deux plages d'accueil de connecteur, dans laquelle :
ledit pilote commun (A) est configuré pour piloter une première desdites au moins deux parties électroniques via une carte flexible (3) prescrite raccordée au premier connecteur de FPC (4A) ;
ledit pilote commun (A) est configuré pour piloter une seconde desdites au moins deux parties électroniques via une carte flexible prescrite raccordée à un second connecteur de FPC (4B) comprenant au moins deux broches (1-10) et pouvant être raccordé à une seconde desdites au moins deux plages d'accueil de connecteur lorsque le premier connecteur de FPC (4A) est déconnecté de la première desdites au moins deux plages d'accueil de connecteur ; et
**caractérisée en ce que**
les première et secondes desdites au moins deux plages d'accueil de connecteur sont agencées du même côté de la carte de circuit imprimé et de sorte que l'espace pour monter le premier connecteur de FPC (4A) sur la première desdites au moins deux plages d'accueil de connecteur recouvre partiellement l'espace pour monter le second connecteur de FPC (4B) sur la seconde desdites au moins deux plages d'accueil de connecteur.

2. Carte de circuit imprimé selon la revendication 1, comprenant en outre au moins deux plages d'accueil de contrôle (8, 8A, 8B) montées sur les formes prescrites et configurées pour permettre une vérification de câble pour les au moins deux parties électroniques, dans laquelle une première des au moins deux plages d'accueil de contrôle est configurée pour permettre une vérification de câble pour la première des parties électroniques et est agencée sur une région sur laquelle le second connecteur de FPC (4B) est configuré pour être monté ou est recouverte par la carte flexible (3) raccordée au second connecteur de FPC (4B) lorsque le second connecteur de FPC (4B) est monté.

3. Carte de circuit imprimé selon la revendication 2, dans laquelle la direction de raccordement des premier et second connecteurs de FPC (4A, 4B) est le même et la carte de circuit imprimé est configurée de sorte que la seconde desdites plages d'accueil de connecteur est partiellement recouverte par la carte flexible (3) raccordée au premier connecteur de FPC (4A).

4. Appareil d'imagerie comprenant une carte de circuit imprimé (2) selon l'une des revendications 1 à 3, dans lequel lesdites parties électroniques comprennent une unité de lentille ayant un cône de caméra, un élément optique (6) et un moteur configuré pour déplacer l'élément optique (6) dans le cône de caméra.
